# EUROPEAN PATENT APPLICATION

(11) **EP 4 793 627 A1**
(43) Date of publication of application: **19.08.2026**
(21) Application number: 26159048.3
(22) Date of filing: 17.02.2026
(51) Int. Cl.: G01N 21/3504, B81B 7/00

(54) **MEMS DEVICE, OPTICAL GAS SENSOR DEVICE, MANUFACTURING METHOD FOR MEMS DEVICE, AND MANUFACTURING METHOD FOR OPTICAL GAS SENSOR DEVICE**

(30) Priority: 18.02.2025 JP 2025023958; 18.02.2025 JP 2025023959; 18.02.2025 JP 2025023960
(71) Applicant: Mitsumi Electric Co., Ltd., Tama-Shi, Tokyo 206-8567 (JP)
(72) Inventor: TAKAHASHI, Akira, Tokyo, 206-8567 (JP)
(74) Representative: Epping - Hermann - Fischer

(57) **Abstract**

A MEMS device, including: a MEMS element (2, 4) that has a space surrounded by an outer peripheral frame from four directions, has a thin film closing the space from an upper surface of the outer peripheral frame, and has an electrode pad (P1 to P4) for wire bonding on the outer peripheral frame; a mount (213) on which the MEMS element is mounted; and a plurality of adhesive areas (241 to 244) that bonds the MEMS element to the mount and are arranged on a plane of the mount. At least one of the plurality of adhesive areas is arranged at a position corresponding to the electrode pad in the plane.

## Description

### BACKGROUND OF THE INVENTION

### TECHNICAL FIELD

The present disclosure relates to a MEMS device, an optical gas sensor device, a manufacturing method for a MEMS device, and a manufacturing method for an optical gas sensor device.

### DESCRIPTION OF RELATED ART

It is known in the prior art that gas concentrations have been constantly observed from the viewpoint of management and worker safety related to chemical substances in homes, factories, and offices. Non-dispersive infrared absorption (NDIR: Non Dispersive InfraRed) gas sensors that detect the concentrations of gases such as CO₂ are known in the observation of gas concentrations. The NDIR gas sensor is a sensor that utilizes the property of many gases to absorb their own specific infrared wavelengths to detect which and how much wavelength is absorbed when infrared rays are emitted to a gas as a detection target and measure the concentration of the gas as a detection target. For example, the NDIR gas sensor is a gas sensor that includes an infrared light source and an infrared light receiver, and detects the concentration of the detected gas in the optical path of the light source and the light receiver.

Each of the light source and the light receiver is constituted by a micro electro mechanical system (MEMS) having a membrane. As a method of modularizing these, each of MEMS elements as the light source and the light receiver is mounted on a substrate. For example, a sensor device is known which includes a function layer having a heating device on a diaphragm region having a plurality of pressure equalization holes and a side wall (see WO 2017/148715). The side wall is mounted on a carrier substrate via a bonding layer.

WO 2017/148715 does not disclose a pad for the sensor device. The MEMS element has a pad which is an electrode for ball bonding as a kind of wire bonding. The ball bonding is solid phase bonding in which a tip of a bonding wire is melted by electrical discharge and solidified into a ball to form an initial ball (referred to as Free Air Ball (FAB)), which is then bonded to the pad, so that solid metals are bonded to one another.

However, in the conventional configuration, there is a concern that a state may occur in which a bonding material (die attach material) required when an MEMS element is mounted on a substrate is not filled between a mount (substrate) and a pad (MEMS element bottom surface). In this state, an ultrasonic wave during wire bonding and pad heating using a hot plate become insufficient, leading to unstable wire bonding connection quality.

As a measure against this, there is a method of providing unevenness on the substrate side to secure the adhesiveness between the substrate and the MEMS element bottom surface, but microprocessing is required, making it difficult to manufacture the substrate. In order to heat the pad, it is considered to increase the setting temperature of the hot plate, but the characteristics of the MEMS element may make it difficult to increase the temperature.

### SUMMARY OF THE INVENTION

An object of the present disclosure is to easily achieve stable wire bonding quality.

To achieve the above-described object, according to an aspect of the present disclosure, there is provided a MEMS device, comprising:
a MEMS element that has a space surrounded by an outer peripheral frame from four directions, has a thin film closing the space from an upper surface of the outer peripheral frame, and has an electrode pad for wire bonding on the outer peripheral frame;
a mount on which the MEMS element is mounted; and
a plurality of adhesive areas that bonds the MEMS element to the mount and are arranged on a plane of the mount, wherein
at least one of the plurality of adhesive areas is arranged at a position corresponding to the electrode pad in the plane.

In addition, according to an aspect of the present disclosure, there is provided a manufacturing method for a MEMS device, the method comprising:
arranging at least one of a plurality of adhesive areas at a position corresponding to an electrode pad for wire bonding in a plane of a mount on which a MEMS element is mounted which has a space surrounded by an outer peripheral frame from four directions, has a thin film closing the space from an upper surface of the outer peripheral frame, and has the electrode pad on the outer peripheral frame; and
mounting to bond and mount the MEMS element on the plurality of adhesive areas.

### BRIEF DESCRIPTION OF THE DRAWINGS

The accompanying drawings are not intended as a definition of the limits of the invention but illustrate embodiments of the invention, and together with the general description given above and the detailed description of the embodiments given below, serve to explain the principles of the invention, wherein:
FIG. 1 is a schematic diagram of an optical gas sensor device of a first embodiment of the present disclosure;
FIG. 2 is a perspective view of the optical gas sensor device;
FIG. 3 is a partially transparent perspective view of the optical gas sensor device;
FIG. 4 is a perspective view illustrating a seal;
FIG. 5 is a cross-sectional view of a light source;
FIG. 6 is a plan view illustrating the light source;
FIG. 7 is a partially transparent plan view of the light source;
FIG. 8 is a partially transparent plan view of a light source in a first modification example;
FIG. 9 is a diagram illustrating a seal on which a light source in a second modification example is mounted;
FIG. 10 is a cross-sectional view of a light source in a second embodiment; and
FIG. 11 is a partially transparent plan view of the light source in the second embodiment.

### DETAILED DESCRIPTION

Hereinafter, a first embodiment, a first modification example, a second modification example, and a second embodiment according to the present disclosure will be described in detail in turn with reference to the accompanying drawings. However, the scope of the invention is not limited to the illustrated examples.

### (First Embodiment)

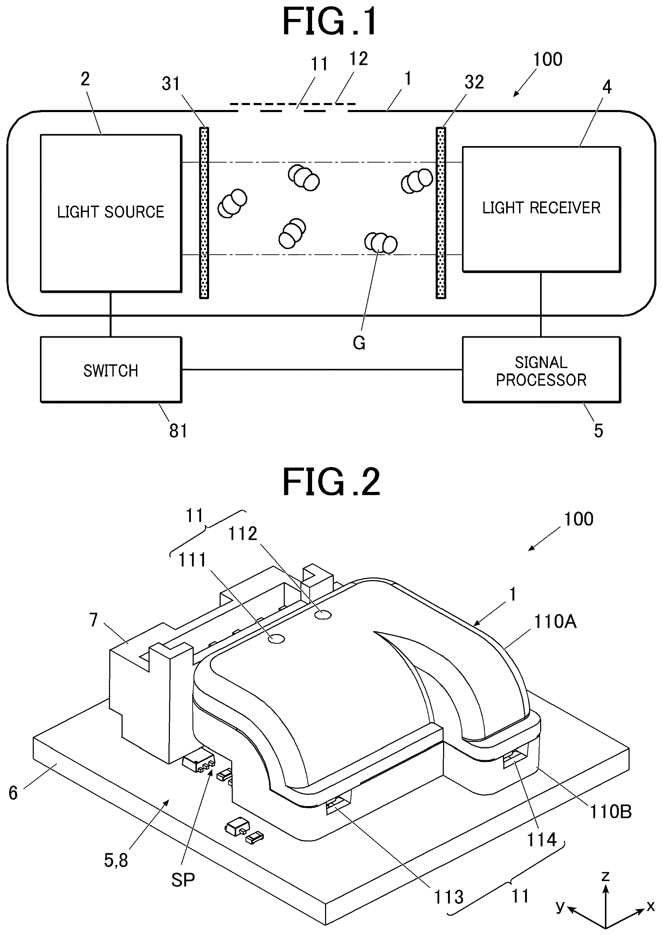

The first embodiment of the present disclosure will be described with reference to FIGS. 1 to 7. First, a schematic configuration of an optical gas sensor device 100 of the present embodiment will be described with reference to FIG. 1. FIG. 1 is a schematic diagram of the optical gas sensor device 100 of the present embodiment.

FIG. 1 illustrates the optical gas sensor device 100 (NDIR system) of the present embodiment. The optical gas sensor device 100 includes an optical cover 1, a light source 2, an anti reflection (AR) filter 31 (or the other optical filter), a λ (wavelength) selection filter 32, a light receiver 4, a signal processor 5, and a switch 81. The AR filter 31 and the λ selection filter 32 are optical filters. In the optical gas sensor device 100, the light source 2 radiates (emits, or emits light of) infrared rays. The radiated infrared rays are emitted to a gas G as a detection target (measurement target) inside the optical cover 1 through an optical path (path) inside the optical cover 1 and the AR filter 31. The AR filter 31 is a filter that prevents the reflection of infrared rays and transmits the infrared rays, alternatively may be an optical filter also having other functions in addition to functions of preventing the reflection of infrared rays and having high transmittance of infrared rays.

The molecules of the gas G as the detection target present in the optical path absorb infrared rays, which reduces the amount of light reaching the light receiver 4. The optical gas sensor device 100 detects the infrared rays partially absorbed by the gas G as the detection target by the light receiver 4 through the λ selection filter 32. The λ selection filter 32 is a filter that transmits the infrared rays of the absorption wavelength of the gas G from the incident infrared rays. This configuration prevents the light receiver 4 from receiving light of pre-filtered infrared rays emitted from sources other than the light source 2, improving the signal-to-noise ratio (SN ratio) as a sensor.

The optical gas sensor device 100 detects (measures) and outputs the concentration of the gas G as the detection target by signal processing the detection signal detected by the light receiver 4 by the signal processor 5. The signal processor 5 has a function of amplifying the analog detection signal detected by the light receiver 4 and converting the analog detection signal into a digital signal to output the digital signal. The switch 81 is a switch that turns on/off the light emission of the light source 2 and is included in a circuit element 8, which is described below. The signal processor 5 further has a function of turning on/off the light source 2 via the switch 81 when performing gas detection.

The optical cover 1 has a gas inlet port 11 as a gas inlet part which is a port for leading the gas G as the detection target in and out. A contamination filter 12 is affixed to the gas inlet port 11. The contamination filter 12 is a metal mesh filter, a resin porous film, or the like to prevent foreign matter from entering from the outside.

Thus, the optical gas sensor device 100 receives the infrared rays emitted from the light source 2 onto the gas G as the detection target by the light receiver 4 after filtering the infrared rays with the AR filter 31 and the λ selection filter 32. The AR filter 31 is placed at a position near the light source 2 on the optical path downstream of the light source 2. The λ selection filter 32 is placed at a position near the light receiver 4 on the optical path upstream of the light receiver 4.

Alternatively, a configuration may be adopted in which the AR filter 31 is placed at a position near the light receiver 4 on the optical path upstream of the light receiver 4. In this configuration, the λ selection filter 32 may be placed at a position near the light source 2 on the optical path downstream of the light source 2.

In the present embodiment, the optical path is formed so that the infrared rays emitted from the light source 2 reflect off the inner surface of the optical cover 1, reach the light receiver 4, and are received by the light receiver 4. The reflectivity is increased by forming a reflective film on the inner surface of the optical cover 1, so that the utilization efficiency of light (infrared rays) is increased. The optical path of the infrared rays received by the light receiver 4 may include not only the optical path that reflects off the inner surface of the optical cover 1 but also the optical path that reaches directly from the light source 2.

In the present embodiment, the light source 2 and the AR filter 31 are configured to be packaged as a seal which is one component. Similarly, the λ selection filter 32 and the light receiver 4 are configured to be packaged as a seal which is one component.

The optical gas sensor device 100 detects, for example, an alternative chlorofluorocarbon refrigerant, which is a refrigerant of an air conditioner, as the gas G as the detection target. Alternative chlorofluorocarbons are synthetic compound (gas) refrigerants that are industrially used as substitutes for specific chlorofluorocarbons (abbreviated as CFC). CFC refrigerants have a high ozone depletion potential and cause depletion of the earth's ozone layer, so the CFC refrigerants have started to be replaced with hydrochlorofluorocarbon (HCFC) refrigerants with low ozone depletion potential. In addition, developed countries are converting from HCFC refrigerants to an HFC refrigerant (R410A) having zero ozone depletion potential.

CFC refrigerants, HCFC refrigerants, and HFC refrigerants have high global warming potentials and are known to cause global warming as greenhouse gases. Therefore, replacement of the HFC refrigerant (R410A) with an HFC refrigerant (R32) having a lower global warming potential is being considered. In the present embodiment, for example, R32 as a fluorocarbon refrigerant is detected as the gas G as the detection target.

The optical gas sensor device 100 outputs various state signals based on the detected gas concentration value of the gas G to an information processor of an apparatus that performs processing based on the state of the optical gas sensor device 100. The information processor is, for example, a micro controller unit (MCU). The state signals are, for example, a failure signal, an alarm signal, and a monitoring signal (normal signal). The failure signal indicates the failure state of the optical gas sensor device 100. The alarm signal indicates that the detected concentration of the gas G is an abnormal state (alarm state) that requires an alarm. The monitoring signal indicates that the detected concentration of the gas G is in a normal state. When the apparatus is an alarm, the alarm issues a notification of various alarms (for example, an alarm of a failure of the optical gas sensor device 100 based on a failure signal, an alarm of an abnormality in the detected concentration of the gas G based on an alarm signal) according to various signals received from the optical gas sensor device 100. The apparatus may be an apparatus including the optical gas sensor device 100 and the MCU, or may be a separate apparatus from the optical gas sensor device 100. The above-described apparatuses include room air conditioners, air conditioners for stores and offices, and multi air conditioners for buildings.

However, the gas G as the detection target is not limited to R32 but may be any other fluorocarbon refrigerant. Furthermore, the gas G as the detection target is not limited to fluorocarbon refrigerants. The gas G as the detection target may be a gas harmful to environment and living beings such as carbon dioxide, carbon monoxide, propane, methane, butane, ammonia, oxygen disulfide, nitrogen dioxide, nitrogen monoxide, ozone, sulfur hexafluoride, or ethylene.

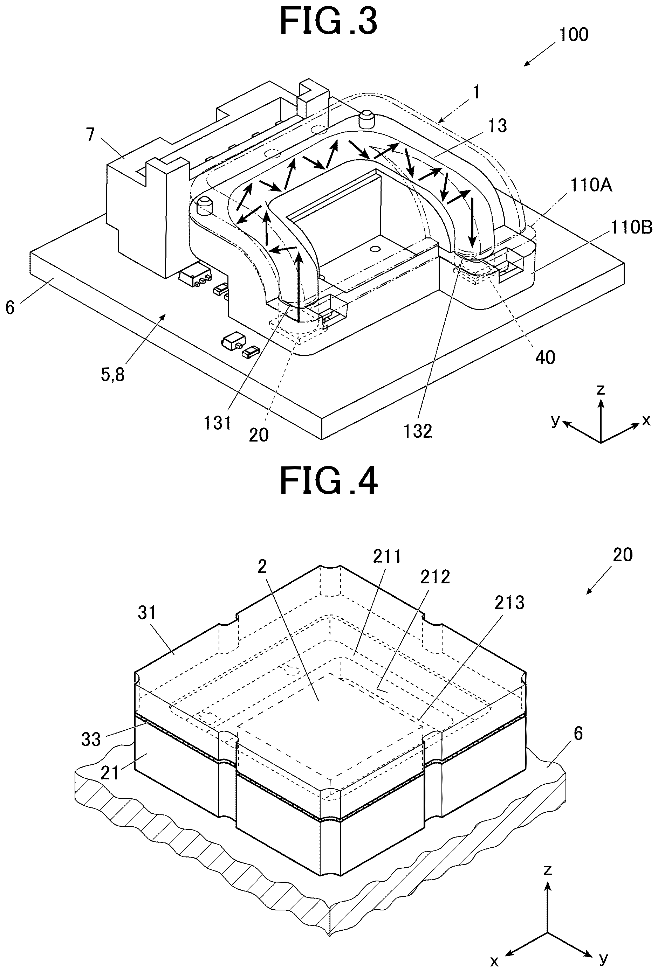

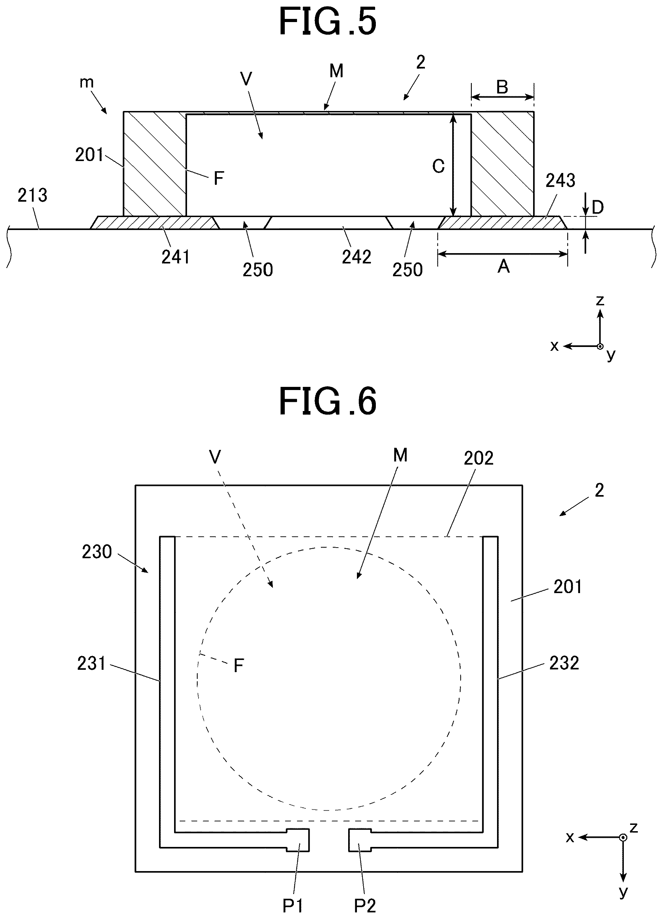

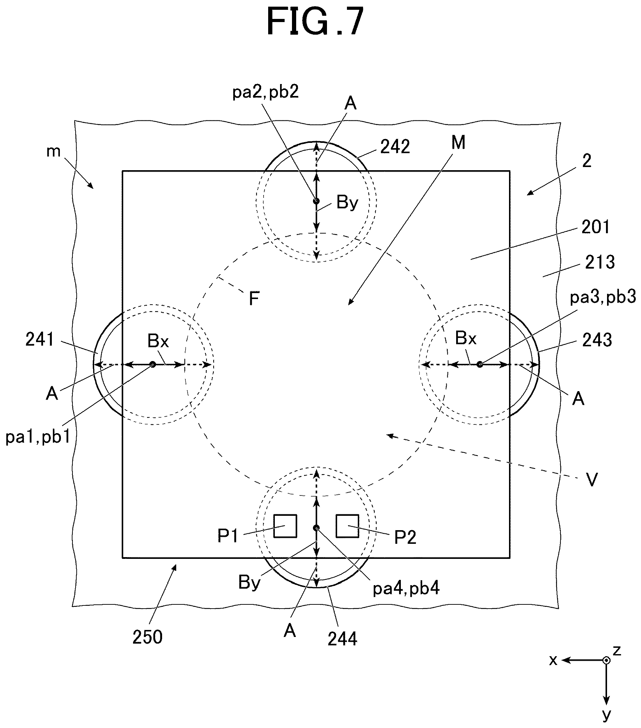

Subsequently, a specific device configuration of the optical gas sensor device 100 will be described with reference to FIGS. 2 to 7. FIG. 2 is a perspective view of the optical gas sensor device 100. FIG. 3 is a partially transparent perspective view of the optical gas sensor device 100. FIG. 4 is a perspective view illustrating a seal 20. FIG. 5 is a cross-sectional view of the light source 2. FIG. 6 is a plan view illustrating the light source 2. FIG. 7 is a partially transparent plan view of the light source 2.

As illustrated in FIGS. 2 and 3, the optical gas sensor device 100 includes the optical cover 1, the seal 20 and a seal 40, the signal processor 5, a substrate 6, a connector 7, and the circuit element 8. The seal 20 has the light source 2 and the AR filter 31. The seal 40 has the λ selection filter 32 and the light receiver 4. The x-axis, y-axis, and z-axis are illustrated in FIG. 2. These three axes are the same in the other figures. In FIGS. 2 and 3, the contamination filter 12 is not illustrated.

The optical cover 1 is a cover that is mounted on the surface on a +z direction side of the substrate 6, covering (encompassing) the seals 20 and 40. The optical cover 1 forms a cavity (space) in which the gas G as the detection target can be housed, and the gas G as the detection target is led into and out of the cavity through the gas inlet port 11. A base of the optical cover 1 is made of resin, for example.

As illustrated in FIG. 2, the optical cover 1 has covers 110A and 110B. The cover 110A is an upper side (+z direction side) part, and is attached to the cover 110B and integrated by bonding, heat caulking, or other methods. The cover 110B is a lower side (-z direction side) part, and is attached to the cover 110A and integrated by bonding, heat caulking, or other methods.

As illustrated in FIG. 3, the optical cover 1 has a light guide 13 as a cavity into which the gas G as the detection target is introduced. The light guide 13 is a pipe-shaped optical path and has a circular cross section perpendicular to the axial direction. The cover 110A has a half pipe. The cover 110B has a half pipe. The half pipes of the covers 110A and 110B are combined to form the light guide 13. Thus, the optical cover 1 has the covers 110A and 110B divided by the axial cross section of the light guide 13. As illustrated in FIG. 3, the light guide 13 has a three-dimensional and substantially U-shape when viewed from the +z direction side (in the xy plane view).

The inner surface of the light guide 13 is covered by an infrared reflective film. Gold is used as the infrared reflective film in the present embodiment, but the present disclosure is not limited thereto. Silver or aluminum may also be used as the infrared reflective film. In addition, a protective film such as a silicon oxide or a silicon nitride may be deposited on the infrared reflective film to prevent corrosion of the metallic film of the infrared reflective film, if necessary. Plating, sputtering, and vacuum evaporation methods can be used to deposit the infrared reflective film and the protective film. For example, the optical cover 1 may be made of a single piece of metal such as aluminum using a metal 3D printer. In either case, it is preferable that the inner surface of the light guide 13 has a mirror finish to reflect infrared rays efficiently.

The light guide 13 reflects the infrared rays emitted from the light source 2 of the seal 20 and made incident through the AR filter 31 with the infrared reflective film on its inner surface. The light guide 13 emits the reflected infrared rays to the light receiver 4 through the λ selection filter 32 of the seal 40. Thus, the optical cover 1 serves as the optical path that reflects the infrared rays emitted from the light source 2 with the infrared reflective film and efficiently guides the infrared rays emitted from the light source 2 to the light receiver 4 so that at least part of the reflected light reaches the light receiver 4 through the λ selection filter 32.

In the present embodiment, the optical path inside the optical cover 1 serves as the light guide 13 in the form of a pipe having a circular cross section perpendicular to the axial direction. This keeps the reflection angle of the infrared rays constant in any direction in three dimensions (x-axis, y-axis, and z-axis) regardless of the diameter or path of the cross section of the light guide 13, so that the infrared rays emitted from the light source 2 can reflect off the inside of the light guide 13 and efficiently enter the light receiver 4. Alternatively, the cross section of the optical path of the light guide 13 of the optical cover 1, the cross section being perpendicular in the axial direction, may have an elliptical shape or a shape formed by combining a curved line with a straight line.

The length of the optical path of the infrared rays from the light source 2 to the light receiver 4 can be changed relatively easily by changing the diameter of the cross section of the light guide 13.

As illustrated in FIGS. 2 and 3, the optical cover 1 is designed and formed in three dimensions so that a space SP can be created on the substrate 6 below (-z direction) a portion of the light guide 13 with the axial direction being the x-axis direction. In the space SP, at least a part of the signal processor 5 and the circuit element 8 are arranged and mounted on the substrate 6.

The cross-sectional area of the cross section of the light guide 13, the cross section being perpendicular to the axial direction, is constant in the axial direction for the main portion (other than an entrance 131 and an exit 132 described below). Since the cross-sectional area is constant, the gas concentration per unit volume is easily homogenized for the gas G as the detection target entering the light guide 13, and since the infrared rays do not pass through a specific path but pass randomly, the infrared rays are easily reactive to changes in the gas concentration of the gas G. FIG. 3 illustrates the state of optical path propagation, with a plurality of optical paths of infrared rays in the light guide 13 indicated by solid arrows. Thus, the optical paths of infrared rays are random within the light guide 13.

The infrared rays emitted from the light source 2 are incident on the light guide 13 on the -x direction side through the AR filter 31. The light guide 13 on the -x direction side has an axial direction extending from the -z direction side to +z direction side, then bends in an R shape and extends straight from the -y direction side to the +y direction side. The end of the light guide 13 on the incident side of infrared rays is the entrance 131. The light guide 13 extending in the +y direction side bends in an R shape, and the axial direction extends from the -x direction side to the +x direction side and bends in an R shape again.

The light guide 13 on the +x direction side has the axial direction extending straight from the +y direction side to the -y direction side, then bends in an R shape and extends to the -z direction side. The infrared rays passing through the light guide 13 are emitted to the λ selection filter 32 and the light receiver 4. The end of the light guide 13 on the infrared ray emitting side is the exit 132.

The exit 132 has a tapered shape in which the cross-sectional area becomes smaller as the axial direction of the light guide 13 moves from the +z direction side to the -z direction side. Similarly, the entrance 131 has a tapered shape in which the cross-sectional area becomes smaller as the axial direction of the light guide 13 moves from the +z direction side to the -z direction side. This can increase the degree of light collection of infrared rays radiated through the light guide 13 to the light receiver 4. r The covers 110A and 110B have hollow portions (not illustrated) as spaces for lightening purpose. These hollow portions enable the optical cover 1 (the optical gas sensor device 100) to be lightweight.

The cover 110B has a fixing pin (not illustrated). The fixing pin is a projection extending in the +z direction, and is fitted into a recess (female hole) (not illustrated) of the cover 110A and integrated by bonding, heat caulking, or other methods. The fixing pin is fitted into the recess of the cover 110A and is integrated by bonding, heat caulking, or other methods, so that the covers 110A and 110B are positioned and fixed together to form a single component.

As illustrated in FIG. 2, the cover 110A has gas intake ports 111 and 112 as the gas inlet ports 11. The cover 110B has gas intake ports (gas inlet holes) 113 and 114 as the gas inlet ports 11. The gas intake ports 111 and 112 are holes drilled in the -z direction from the upper surface of the cover 110A and extending to the light guide 13. The gas intake port 113 is a hole drilled in the +y direction from the side surface of the cover 110B in the -y direction and extending to the space around (beside) the seal 20. The space around the seal 20 is conductive to the light guide 13. The gas intake port 114 is a hole drilled in the +y direction from the side surface of the cover 110B in the -y direction and extending to the space around (beside) the seal 40. The space around the seal 40 is conducive to the light guide 13.

The gas intake ports 111 and 112 are directly conductive to the light guide 13, and since a part of the inner surface of the light guide 13 is removed, the utilization efficiency of infrared rays is reduced. In contrast, the gas intake port 113 is indirectly conductive to the light guide 13 through the space around the seal 20, thereby increasing the utilization efficiency of infrared rays without ruining (removing) a part of the inner surface of the light guide 13. Similarly, the gas intake port 114 is indirectly conductive to the light guide 13 through the space around the seal 40, thereby increasing the utilization efficiency of infrared rays without ruining a part of the inner surface of the light guide 13.

The shape, size and position of the gas inlet ports 11 (gas intake ports 111, 112, 113, and 114) of the optical cover 1 in FIG. 2 are examples, and the present disclosure is not limited thereto.

As illustrated in FIG. 4, the seal 20 is mounted on the substrate 6 and hermetically closes and seals the light source 2 in the seal 20. The seal 20 protects the light source 2 from the external environment such as the humidity outside the seal 20, that is, the humidity inside and outside the space surrounded by the cover 110A and the cover 110B, and the environmentally affected gases. In the seal 20, the light source 2 is mounted on the bottom (bottom surface 213) of the space surrounded by a protective cover, for example, a ceramic substrate 21 in the present embodiment by being bonded with adhesive areas 241 to 244 (see FIG. 5), and the AR filter 31 or the other optical filter is bonded on the upper surface of the ceramic substrate 21 with an adhesive 33, so that the light source 2 is sealed in the seal 20.

The ceramic substrate 21 is made of, for example, ceramic and protects the light source 2 from the side surfaces and the bottom surface. The ceramic substrate 21 is directly mounted on the bottom of the seal 20 or the substrate 6. The ceramic substrate 21 has no vent, and the AR filter 31 or the other optical filter is mounted on the ceramic substrate 21.

The ceramic substrate 21 has recesses 211 and 212. The recess 211 is a recess located on the upper surface (+z direction) side and has an opening formed in a substantially rectangular planar shape. The recess 212 is a recess located on the lower surface (-z direction) side of the recess 211 and has an opening that is formed in a substantially rectangular planar shape and is smaller than the recess 211. The recess 212 has the bottom surface 213, and the light source 2 is bonded and mounted on the bottom surface 213. The ceramic substrate 21 electrically connects a terminal, which is wire-bonded with the light source 2, to a terminal of the substrate 6, for example, by means of through holes.

The AR filter 31 is placed over the entire surface of the upper surface of the ceramic substrate 21 to cover the opening in the upper surface and is attached to the ceramic substrate 21 by means of the adhesive 33. The adhesive 33 is epoxy or silicone resin for hermetic sealing of the light source 2. The adhesive 33 may also be a glass frit material for sealing the light source 2, or a preform or paste of a metallic material such as AuSn or solder. In a case of the metallic material, it is desirable that the ceramic substrate 21 and the AR filter 31 to be bonded are metallized with Cr/Ni/Au or Ti/Ni/Au in the adhesive area to ensure the adhesion.

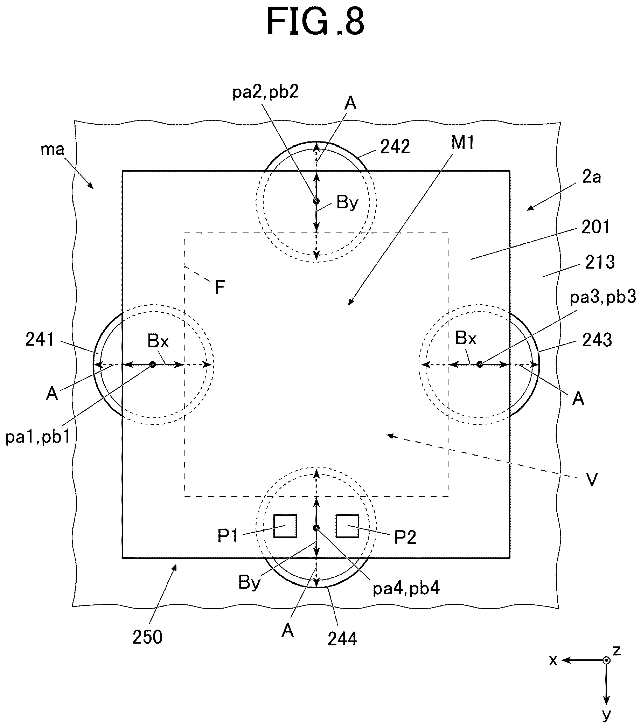

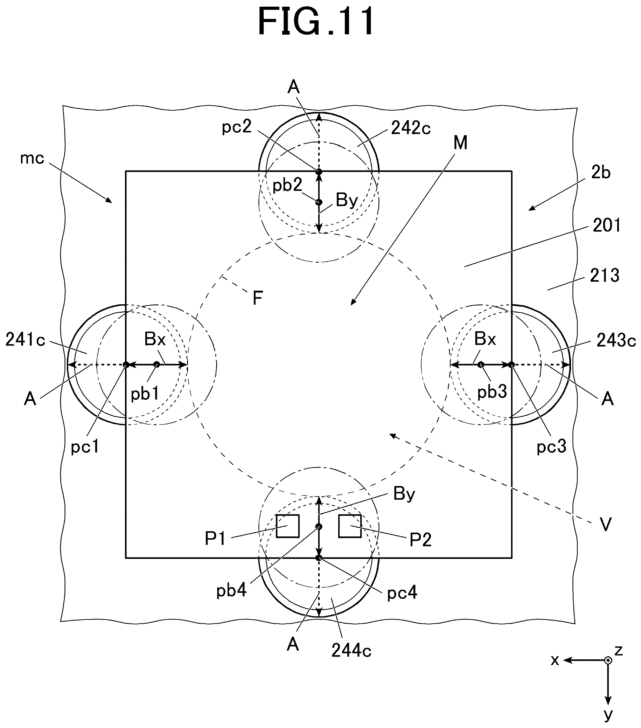

As illustrated in FIGS. 5 and 7, in the optical gas sensor device 100, a MEMS device m includes the light source 2 as a MEMS element, the bottom surface 213 of the seal 20 as the mount, and the adhesive areas 241, 242, 243, and 244. In FIG. 7 (and FIGS. 8 and 11 described below), electrodes are omitted for clarity. The light source 2 is a MEMS-type light source mounted on the upper surface (surface on the +z direction side) of the bottom surface 213, and has a membrane M of a membrane structure formed on an Si support layer 201, and in the membrane M, a planar heater layer 202 (FIG. 6) is formed to cover a space V.

As illustrated in FIG. 6, the light source 2 has a light source region 230 and electrode pads P1 and P2 when viewed from the +z direction side (in the xy plane view). The light source region 230 is a region functioning as a substantially rectangular light source and has electrodes 231 and 232. The electrode 231 extends in the y-axis direction and is located on the +x direction side of the light source region 230. The electrode 231 is electrically connected to the electrode pad P1 via the wiring. The electrode 232 extends in the y-axis direction and is located at an end on the -x direction side of the light source region 230. The electrode 232 is electrically connected to the electrode pad P2 via the wiring.

The light source 2 has a cross-sectional configuration in which, for example, the Si support layer 201, a heater layer support layer, the heater layer 202, the electrodes 231 and 232, an electrode support layer, and a protective layer (those without reference numerals are not illustrated) are stacked in this order from the -z direction side to the +z direction side. The heater layer support layer, the electrode support layer, and the protective layer are insulating layers that sandwich the heater layer 202 from the upper and lower sides in the z-axis direction.

The Si support layer 201 is a substrate made of Si and is a support layer that supports an upper layer such as the membrane M of the light source 2. As illustrated in FIGS. 6 and 7, the Si support layer 201 has the space V having a circular shape (cylindrical shape) as a round shape when viewed from the -z direction side. The space V is surrounded by an outer peripheral frame F of the Si support layer 201 from four directions. Therefore, the light source 2 has the membrane M having a round shape (circular shape) on the xy plane perpendicular to a film thickness direction (z-axis direction). The membrane M covers the space V from the upper surface (+z direction side) of the outer peripheral frame F.

The heater layer support layer has, for example, a silicon oxide film, a silicon nitride film, and a silicon oxide film from the -z direction side to the +z direction side. The silicon oxide film is a thin film made of silicon dioxide (SiO₂) as an insulator (dielectric). The heater layer support layer may have a configuration in which the silicon oxide film on the -z direction side is not provided in the membrane M. The silicon nitride film is a thin film made of silicon nitride (Si₃N₄) as an insulator (dielectric). The silicon oxide film is a thin film made of SiO₂. The heater layer 202 is a thin film heater as a light source (metal) layer, generates heat when energized, and heats the membrane M. The heated membrane M radiates infrared rays with intensity and wavelength dependence on surface temperature and surface emissivity. The heater layer 202 is made of molybdenum disilicide (MoSi₂), for example. However, the heater layer 202 is not limited thereto, and may be made of the other material such as molybdenum (Mo), a compound having a composition ratio different from MoSi₂ consisting of Mo and Si, tungsten (W), tungsten disilicide (WSi₂), a compound having a composition ratio different from WSi₂ consisting of W and Si, platinum (Pt), titanium (Ti), gold (Au), silver (Ag), nickel chromium (NiCr), nickel (Ni), aluminum (Al), copper (Cu), titanium nitride (TiN), or polycrystalline silicon (polysilicon). The heater layer 202 is formed in a rectangular shape wider than an outer shape of the circular space V on the xy plane, so that the tensile stress is evenly applied to the membrane M region.

The electrodes 231 and 232 are made of metal such as an aluminum-silicon alloy and are arranged to be electrically connected to the heater layer 202. The electrode support layer is made of SiO₂ and supports the electrodes 231 and 232. The protective layer is made of Si₃N₄ and protects a lower layer including the electrode support layer from an external disturbance. The electrodes 231 and 232 are exposed from the upper surface of the protective layer in the +z direction.

The membrane M is a film-like part including the layers except for the Si support layer 201 among the plurality of layers of the light source 2 on the xy plane. That is, the membrane M has, for example, a silicon oxide film, a silicon nitride film, a silicon oxide film, the heater layer 202, the electrode support layer, and the protective layer in this order from the -z direction side to the +z direction side.

The heater layer 202 is electrically connected to the electrodes 231 and 232. The electrode pads P1 and P2 are electrode pads for wire bonding, and the electrode pads P1 and P2 are electrically connected to the electrodes 231 and 232, respectively. The electrode pads P1 and P2 are wire-bonded to the terminals of the wiring patterns on the substrate 6, and the heater layer 202 is energized by the application of voltage.

The light source 2 as a MEMS-type light source is small and low profile and can achieve miniaturization as a sensor module. The light source 2 as a MEMS-type light source is characterized by long life, low power consumption, and short response time, and can achieve lower power consumption of the sensor module as a whole. The short response time of the MEMS-type light source enables a shorter standby time after energizing in case of intermittent driving and reduces the average power consumption.

The light source 2 as a MEMS-type light source can directly utilize the light radiated from the surface of the high-temperature portion, which enables its application to the detection of the gas with absorption bands at high wavelengths. In addition, the regions that radiate infrared rays in the light source 2 are patterned with high precision as the membrane M on the plane of the Si support layer 201, and individual variations in the radiation direction are very small. This reduces the variation in the amount of light received when a sensor module is configured with the light source 2 and contributes to improvement in product yield. In addition, since the light source 2 is produced by batch using the MEMS technology on the basis of silicon wafers, it is excellent in mass-productivity.

Furthermore, in the light source 2, the membrane M has a round shape (circular shape) on the xy plane and is within a region of the heater layer 202, so that the thermal stress generated during heating becomes uniform, and the mechanical strength is improved. This reduces breakage of the membrane M due to the thermal stress during driving and contributes to the extension of the product life.

As illustrated in FIGS. 5 and 7, the light source 2 is bonded to and surface-mounted on the bottom surface 213 through the four adhesive areas 241, 242, 243, and 244. The adhesive areas 241, 242, 243, and 244 are made of an adhesive material and are formed in a circular shape in the xy plane view. The adhesive material is, for example, epoxy resin, silicone, and conductive paste. However, the adhesive material does not require conductivity. The number of adhesive areas of the MEMS device m is not limited to four, and may be other plural number.

In the xy plane, each diameter of the adhesive areas 241, 242, 243, and 244 is defined as an adhesive area diameter A. In addition, in the xy plane, the minimum distance (four places) between the membrane M (outer peripheral frame F) and the outer periphery on the outer side of the Si support layer 201 is defined as an outer peripheral frame width B. Among these, the outer peripheral frame width in the x-axis direction is defined as Bx, and the outer peripheral frame width in the y-axis direction is defined as By. As illustrated in FIG. 5, the height (length in the z-axis direction) of the Si support layer 201 from the bottom is defined as a membrane height C. The thickness of 241, 242, 243, and 244 from the bottom surface 213 to which 241, 242, 243, and 244 are bonded is defined as a thickness D. The thickness D is 5 to 50 µm. The thickness (length in the z-axis direction) of the membrane M is 2 to 2.5 µm and the membrane M has relatively low rigidity.

In the xy plane, the adhesive areas 241, 242, 243, and 244 are intermittently arranged (arranged with intervals) on the bottom surface 213. The adhesive areas 241, 242, 243, and 244 are applied to and arranged on the bottom surface 213 with, for example, a jet type dispenser or an air pulse type dispenser. Alternatively, the adhesive areas 241, 242, 243, and 244 may be transferred on the bottom surface 213 by the pin transfer method using a transfer pin.

The intermittent arrangement of the adhesive areas 241, 242, 243, and 244 forms gaps 250 in the light source 2. If an adhesive area is uniformly arranged on the entire bottom surface, the gas (atmosphere or sealed gas) is hermetically closed in the space V by the adhesive area without gaps formed in the light source. Since the membrane of the light source may break due to volume expansion of sealed gas in a heating process in subsequent assembling, it becomes necessary to provide a step portion for degassing on the mount (bottom surface 213) side. The heating process is, for example, a heating process in a reflow oven or a heating process in an oven at the time of mounting through the use of a surface mount technology (SMT). The reflow oven is a device that performs preheating, main heating, and cooling on a substrate and a mount component, and supplies heat required for melting solder paste for soldering. Heating in the oven is a process in which a component is mounted on a substrate and then, heating is performed to adjust the characteristics.

However, since the intermittent arrangement of the adhesive areas 241, 242, 243, and 244 forms the gaps 250 in the light source 2, the gaps 250 make it unnecessary to provide the step portion for degassing on the mount (bottom surface 213) side. Accordingly, the membrane M can be prevented from breaking in the heating process in the subsequent assembling. Specifically, the gas is discharged from the gap 250, enabling the subsequent assembling without causing breakage of the membrane M due to a load on the membrane M.

In the intermittent arrangement of the adhesive areas 241, 242, 243, and 244, it is preferable that the ratio of the bonding region = (area of bonding region of adhesive area in mount component (bottom surface 213))/(area of non-bonding region) is set to 14% or more and 50% or less in the xy plane view. Since the membrane of the light source 2 has a round shape (circular shape), in this shape, it is preferable that the ratio of the bonding region is set to 20 to 34%.

As illustrated in FIG. 7, the adhesive area 244 is arranged in a region surrounding the electrode pads P1 and P2 in the xy plane of the bottom surface 213. In addition, the adhesive areas 241, 242, 243, and 244 are arranged at such positions that the adhesive areas are adjacent to each other at equal intervals in the xy plane of the bottom surface 213. The effects of an ultrasonic wave applying process during wire bonding and an electrode pad heating process are sufficiently exhibited by filling a portion between the mount (bottom surface 213) and the electrode pads P1 and P2 (MEMS bottom surface) for ball bonding with the adhesive area 244, leading to a state in which the wire bonding connection quality is stable. The ultrasonic wave applying process is a process of vibrating a bonding tool such as a capillary or a wedge, which is a tool for wire bonding, with an ultrasonic wave in the xy plane direction when a wire is welded to electrode pads on the xy plane through the bonding tool by a wire bonder. With the vibration, the wire is welded by breaking films of the electrode pads. When the wire is a gold wire, the wire is welded by an ultrasonic wave and heating. When the wire is an aluminum wire, the wire is welded by an ultrasonic wave and pressurization. The electrode pad heating process is a process of heating the light source 2 from the back of the mount (bottom surface 213) using a hot plate to heat the electrode pads P1 and P2 at the time of wire bonding.

Furthermore, regarding the arrangement of the adhesive areas 241 to 244 in the xy plane of the bottom surface 213, the adhesive areas 241 to 244 are adjacent to each other at equal intervals (equal distances), including the adhesive area 244 corresponding to the electrode pads P1 and P2. The adhesive areas 241 to 244 are arranged at equal intervals (equal distances) when the center of the light source 2 is set as a reference in the xy plane of the bottom surface 213. This stabilizes the flatness of the light source 2 with respect to the xy plane, and the bonding tool and the electrode pads P1 and P2 are arranged in a parallel state when the wire bonding is performed, making it easy to apply the ultrasonic wave. Specifically, when the adhesive areas 241, 242, 243, and 244 are provided, the ultrasonic wave emitted from the wire bonder acts efficiently without escaping, so that the metal bonding of the electrode pads P1 and P2 surface with the wire is achieved and the connection reliability can be ensured. This can ensure more stable wire bonding connection quality. However, in methods not using the wire such as a flip chip mounting method, it becomes unnecessary to arrange the adhesive area 244 corresponding to the electrode pads P1 and P2 and arrange the adhesive areas 241 to 244 at equal intervals as described above.

The light source 2 is mounted on and wire-bonded to the bottom surface 213 of the seal 20. The electrode pads P1 and P2 are electrically connected to the terminals of the seal 20 via wires, respectively.

As illustrated in FIG. 7, in the adhesive area 241, 243, a center pa1, pa3 of the adhesive area diameter A is arranged at a position coincident with a midpoint pb1, pb3 of the outer peripheral frame width Bx in the xy plane view. In the adhesive area 242, 244, a center pa2, pa4 of the adhesive area diameter A is arranged at a position coincident with a midpoint pb2, pb4 of the outer peripheral frame width By in the xy plane view.

The AR filter 31 is a filter that prevents the reflection of infrared rays and transmits the infrared rays. The AR filter 31 has, for example, a multilayer film and a silicon substrate as a base material. The multilayer film is formed on the silicon substrate by coating, and the like, and is made of a material such as ZnS or Ge as a dielectric with a smaller refractive index than silicon. The spectral characteristics of the AR filter 31 are θ = 0°, T(AVE) 8.5 to 10.0 µm ≥ 80%, T(ABS) 8.0 to 12 µm ≥ 50%, T(ABS) 1.0 to 6.8 µm ≤ 1.0%, and T7.5 ± 0.4 µm = 5%.

The seal 40 has the same structure as the seal 20. That is, the seal 40 has a configuration in which the AR filter 31 and the light source 2 of the seal 20 are replaced with the λ selection filter 32 and the light receiver 4. For this reason, the description of the protective cover and the other parts of the seal 40 are omitted, and the λ selection filter 32 and the light receiver 4 will be described.

The light receiver 4 is a surface-mount component, mounted on the +z-side surface of the substrate 6, and detects the amount of light of incident infrared rays to output a detection signal as an analog electrical signal. The light receiver 4 is, for example, a thermopile-type optical sensor (infrared sensor) with a plurality of thermocouples, and is also a MEMS element having a membrane like the light source 2. The light receiver 4 has, for example, three electrode pads. However, the light receiver 4 is not limited to the thermopile-type infrared sensor, and may be a quantum type (cooling type) photoelectric tube, a photoconductive type, a photovoltaic type infrared sensor, a thermal type (non-cooling type) pyroelectric element type, a thermocouple type, a bolometer type infrared sensor, or the like. These infrared sensors are also MEMS elements having a membrane.

The λ selection filter 32 is a filter that is provided to cover the light emitting surface of the light source 2 and transmits light (infrared rays) with a wavelength λ corresponding to the inherent absorption wavelength of the gas G as the detection target. Thus, the transmission wavelength of the λ selection filter 32 is designed to match the inherent absorption wavelength of the gas G as the detection target. This reduces changes in light amount due to gases other than the gas G as the detection target and improves the SN ratio of the detection signal of the light receiver 4.

The λ selection filter 32 has, for example, a silicon substrate as a base material and a dielectric multilayer film or a multilayer film made of an infrared transmitting material such as Si, Ge, sulfide and fluoride. The silicon substrate is a flat silicon substrate. However, the material of the substrate is not limited silicon, but the substrate can be made of germanium (Ge), quartz (SiO₂), alumina (Al₂O₃), barium fluoride (BaF₂), calcium fluoride (CaF₂), or the like. The multilayer film is a multi-layered film provided on each side of the silicon substrate. The planar shape of the λ selection filter 32 is rectangular, but is not limited to this, and may be circular or other shapes.

The λ selection filter 32 is a bandpass filter that transmits light in the wavelength band including the absorption wavelength of the gas G. The λ selection filter 32 may be configured to apply a long pass filter that cuts light on the shorter wavelength side than an arbitrary cutoff wavelength and transmits light including the absorption wavelength of the gas G on the longer wavelength side.

The signal processor 5 is mounted on a plane region other than the optical cover 1 on the +z-side surface of the substrate 6 and is an analog front end (AFE)-integrated circuit (IC) as an electronic component (processor) that performs signal processing related to the detection signal of the light receiver 4. The signal processor 5 amplifies and AD-converts the analog detection signal of the light receiver 4 and generates the difference value of the detection value when the light source 2 is off from the detection value when the light source 2 is on. The signal processor 5 applies corrections for temperature and individual variation of the optical gas sensor device 100 to the difference value of the detection values and generates various state signals from the difference values of the digital detection values. The signal processor 5 outputs the difference values of the digital detection values and the state signals.

The substrate 6 is a flame retardant type-4 (FR-4) printed circuit board (PCB) with a conductor wiring printed on a board made of glass epoxy resin or the like. On the +z-side surface of the substrate 6, the optical cover 1, the seals 20 and 40, the signal processor 5, the connector 7, and the circuit element 8 are mounted. The +z-side surface of the substrate 6, the light emitting surface of the light source 2, the AR filter 31, the λ selection filter 32, and the light receiving surface of the light receiver 4 are in a substantially parallel relationship.

The connector 7 is a connector mounted on the plane region other than the optical cover 1 and the signal processor 5 on the +z-side surface of the substrate 6 and used to output various digital signals output from the signal processor 5 to the information processor of later apparatus (for example, an alarm). The connector 7 is connected to the information processor of the apparatus via a cable with a plug.

The circuit element 8 includes a switch such as the switch 81, an amplifier, a chip resistor, a chip capacitor, and other circuit elements. The switch 81 is an N-channel metal-oxide-semiconductor field effect transistor (NMOSFET) or a complementary metal-oxide-semiconductor (CMOS) field effect transistor.

Next, a manufacturing method for the optical gas sensor device 100 will be briefly described. Here, in the manufacturing method for the optical gas sensor device 100, a manufacturing method for the seals 20 and 40 as the seals will be mainly described.

A creating process of the seal 20 is the following process. First, the ceramic substrate 21 is created and prepared as a cavity type protective cover. In addition to the ceramic substrate, a glass epoxy substrate may also be used. Next, the light source 2 is mounted (die bonding and wire bonding) on the ceramic substrate 21. Specifically, the adhesive areas 241 to 244 are applied to and arranged on predetermined positions (FIG. 7) of the bottom surface 213 of the ceramic substrate 21 with a jet type dispenser or an air pulse type dispenser. Alternatively, the adhesive areas 241 to 244 are transferred to and arranged on predetermined positions (FIG. 7) of the bottom surface 213 of the ceramic substrate 21 by a pin transfer method. Then, a die bonder is used to pick up the light source 2 as an individual piece and fix and mount the light source 2 to and on predetermined positions (FIG. 7) on the adhesive areas 241 to 244. Furthermore, the wire bonder is used to wire-bond and electrically connect the electrode pads P1 and P2 to the two terminals provided in the ceramic substrate 21, respectively.

Then, as an interpolation in case of no vent, air decompression processing (for example, vacuuming) is performed using, for example, an air intake pump, the adhesive 33 is applied to the ceramic substrate 21 in the decompressed air (for example, vacuum) to attach and install the AR filter 31 to the ceramic substrate 21, and the seal 20 is created. Alternatively, the attachment is performed at a temperature (100°C or higher) higher than normal temperature according to the physical properties of the adhesive material. At this time, in order to reduce an increase in internal pressure due to a rise in temperature, the AR filter 31 is fixed with a heavy stone or jig so as not to move. At this time, it is desirable to install the AR filter 31 at a higher temperature to reduce the load of fixing.

The creating process of the seal 40 is similar to the creating process of the seal 20. First, the ceramic substrate 21 is created and prepared as a cavity type ceramic substrate. Next, the adhesive areas 241 to 244 are arranged on the bottom surface 213 of the ceramic substrate 21. Then, die bonding is used to mount the light receiver 4 on the bottom surface 213 via the adhesive areas 241 to 244. Then, the electrode pads of the light receiver 4 are wire-bonded and electrically connected to the terminals provided in the ceramic substrate 21, respectively. Thereafter, the adhesive 33 is applied to the ceramic substrate 21 to attach and install the λ selection filter 32 to the ceramic substrate 21, and is hardened in the oven or the like, and the seal 40 is created. For the sealing material, thermosetting resin, a preform, high melting point glass, silver paste, or the like may be used.

This blocks between the external environment and the surface of the light source 2 or the light receiver 4, so that the influence of the external environment can be minimized. The height (length in the z-axis direction) of the recess 212 is designed to be adjusted to shorten the distance between the surface of the light source 2 or the light receiver 4 and the AR filter 31 or the λ selection filter 32.

In the other process, in the same manner as the manufacturing method for an optical gas sensor device disclosed in (JP 2025-012828), a plurality of arrayed substrates 6 are created and the signal processor 5 and the circuit element 8 are created in parallel with the seal creating process. The seals 20 and 40 are delivered (stored) in individual pieces. For this reason, the seals 20 and 40 are installed to a jig with a digging pocket in order to make the seals 20 and 40 in a collective substrate form in a pseudo manner. Then, the seals 20 and 40, the signal processor 5, and the circuit element 8 are surface mounted (SMT) on the substrate 6. In SMT of the seals 20 and 40, the seals 20 and 40 on the jig is surface mounted on the substrate 6. In the SMT, the reflow oven heats a main substrate on which the solder paste has been printed, at maximum 260°C, to solder the terminal of each element constituting the signal processor 5 and the circuit element 8 to the terminal of wiring of the main substrate.

In parallel with this, the optical cover 1 to which the contamination filter 12 is affixed is created, and the optical cover 1 is installed to the substrate 6 by bonding or heat caulking. Then, the connector 7 is mounted on the substrate 6. Then, moisture-proof coating is applied to the substrate 6 with a moisture-proof coating material. Then, a dicing device divides the plurality of arrayed substrates 6 to create individual optical gas sensor devices 100. Then, various adjustments are made for the optical gas sensor device 100, and a final inspection of the optical gas sensor device 100 is performed. Then, the optical gas sensor device 100 that is determined to be good in the final inspection is packed and shipped to the destination. At the destination, the optical gas sensor device 100 is heated by an oven to adjust the characteristics. The optical gas sensor device 100 is manufactured through these processes.

There has conventionally been the heating process in the reflow oven at the time of mounting and in the oven after the shipment in a state in which a portion between the mount (substrate) and the MEMS element is hermetically closed by the bonding material (die attach material) required when the MEMS element is mounted on the substrate. The volume expansion of the sealed gas in the heating process may cause breakage (crack) of the membrane part. Therefore, a sensor device is known which includes a function layer having a heating device on a diaphragm region having a plurality of pressure equalization holes and a side wall (see WO 2017/148715). The side wall is mounted on a carrier substrate via a bonding layer. The volume of the gas in the back side cavity surrounded by the function layer of the diaphragm region, the side wall, and the carrier substrate expands by heating, but the pressure equalization holes has a pressure equalizing effect. However, when a plurality of pressure equalization holes are provided and a step portion for degassing is provided in the mount side (substrate) as described above in order to prevent a thin film such as the membrane of the MEMS element or the diaphragm from breaking, the component cost increases due to a complex shape of the structure. In contrast, according to the present embodiment, the MEMS device m includes the light source 2 as the MEMS element that has the space V surrounded by the outer peripheral frame F of the Si support layer 201 from the four directions and has the membrane M as a thin film covering the space V from the upper surface of the outer peripheral frame F, the ceramic substrate 21 as the mount on which the light source 2 is mounted, and the adhesive areas 241 to 244. The adhesive areas 241 to 244 bond the light source 2 to the ceramic substrate 21 and are intermittently arranged so as to have the gaps 250 between the bottom surface 213 and the lower surface of the outer peripheral frame F in the bottom surface 213 as the xy plane of the ceramic substrate 21.

A manufacturing method for the MEMS device m includes an arrangement process of intermittently arranging the adhesive areas 241 to 244 so as to have the gaps 250 between the bottom surface 213 and the lower surface of the outer peripheral frame F in the bottom surface 213 of the ceramic substrate 21 on which the light source 2 having the space V surrounded by the outer peripheral frame F of the Si support layer 201 from the four directions and having the membrane M as a thin film covering the space V from the upper surface of the outer peripheral frame F is mounted, and a mounting process of mounting to bond the light source 2 on the adhesive areas 241 to 244.

Therefore, the gaps 250 are formed, making it possible to prevent breakage of the membrane M due to the volume expansion of the sealed gas in the heating process after the mounting process. At the same time, it is unnecessary to provide a plurality of pressure equalization holes and to provide a step portion for degassing on the mount side (bottom surface 213), making it possible to prevent an increase in component cost.

In addition, the MEMS device m includes the light source 2 as the MEMS element that has the space V surrounded by the outer peripheral frame F of the Si support layer 201 from the four directions, has the membrane M covering the space V from the upper surface of the outer peripheral frame F, and has the electrode pads P1 and P2 for wire bonding on the outer peripheral frame F, the ceramic substrate 21 as the mount on which the light source 2 is mounted, and the adhesive areas 241 to 244. The adhesive areas 241 to 244 bond the light source 2 to the ceramic substrate 21, and in the bottom surface 213 as the plane of the ceramic substrate 21, one adhesive area 244 is arranged at a position corresponding to the electrode pads P1 and P2.

The manufacturing method for the MEMS device m includes the arrangement process and the mounting process. In the arrangement process, one adhesive area 244 is arranged at the position corresponding to the electrode pads P1 and P2 in the bottom surface 213 of the ceramic substrate 21 on which the light source 2 is mounted, the light source 2 having the space V surrounded by the outer peripheral frame F of the Si support layer 201 from the four directions, having the membrane M closing the space V from the upper surface of the outer peripheral frame F, and having the electrode pads P1 and P2 for wire bonding on the outer peripheral frame F. In the mounting process, the light source 2 is bonded and mounted on the adhesive areas 241 to 244.

Therefore, an ultrasonic wave during wire bonding and heating of the electrode pads using a hot plate become sufficient without providing a configuration in which unevenness is provided on the substrate side and without increasing the setting temperature for heating the electrode pads. Accordingly, stable wire bonding quality can be easily achieved with the electrode pads P1 and P2 of the MEMS element.

The adhesive areas 241 to 244 are arranged so that the adhesive areas 241 to 244 are adjacent to each other at equal intervals, including the adhesive area 244. In the arrangement process, the adhesive areas 241 to 244 adjacent to each other including the adhesive area 244 are arranged at equal distances on the bottom surface 213. This stabilizes the flatness of the MEMS element with respect to the xy plane, so that an ultrasonic wave during wire bonding and heating of the electrode pads using a hot plate become more sufficient. Accordingly, stable wire bonding quality can be easily achieved with the electrode pads P1 and P2 of the MEMS element.

The optical gas sensor device 100 includes the light source 2, the AR filter 31 and the λ selection filter 32 as optical filters, the light receiver 4, and the optical cover 1. The light source 2 emits infrared rays to the gas as the detection target. The optical filters transmit the infrared rays emitted from the light source 2 and passing through the gas G as the detection target. The light receiver 4 detects infrared rays incident via the optical filters and generates a detection signal. The optical cover 1 covers the light source 2, the optical filters, and the light receiver 4. The light source 2 and the light receiver 4 are the MEMS elements. Therefore, in the optical gas sensor device 100, it is possible to prevent breakage of the membrane M due to the volume expansion of the sealed gas in the heating process after the mounting process and prevent an increase in component cost. In addition, in the optical gas sensor device 100, stable wire bonding quality can be easily achieved with the electrode pads P1 and P2.

The mount is the ceramic substrate 21 (bottom surface 213) of the seal 20 that seals the light source 2. Therefore, when the mount is the seal 20, it is possible to prevent breakage of the membrane M due to the volume expansion of the sealed gas in the heating process after the mounting process and prevent an increase in component cost. When the mount is the seal 20, stable wire bonding quality can be easily achieved with the electrode pads P1 and P2.

### (First Modification Example)

A first modification example of the first embodiment will be described with reference to FIG. 8. FIG. 8 is a partially transparent plan view of a light source 2a of the first modification example.

An optical gas sensor device in this modification example has a configuration in which the light source 2 and the MEMS device m of the optical gas sensor device 100 in the first embodiment are replaced with the light source 2a and a MEMS device ma, respectively. Therefore, the light source 2a will be mainly described, and the description of similar configurations to those in the first embodiment will be omitted.

As illustrated in FIG. 8, the light source 2a has a similar configuration as the light source 2, but a shape of a membrane M1 is rectangular (square) in the xy plane view.

In an adhesive area 241, 243, the center pa1, pa3 of the adhesive area diameter A is arranged at a position coincident with the midpoint pb1, pb3 of the outer peripheral frame width Bx of the outer peripheral frame F in the xy plane view. In the adhesive area 242, 244, the center pa2, pa4 of the adhesive area diameter A is arranged at a position coincident with the midpoint pb2, pb4 of the outer peripheral frame width By of the outer peripheral frame F in the xy plane view.

In the light source 2a, the membrane M1 has a rectangular shape, and in the intermittent arrangement of the adhesive areas 241, 242, 243, and 244, the ratio of the bonding region is preferably set to 14% to 50%, and the ratio of the bonding region is more preferably set to 23% to 38%.

As described above, according to this modification example, the MEMS device ma including the light source 2a and the optical gas sensor device 100 have the same effects as those in the first embodiment.

### (Second Modification Example)

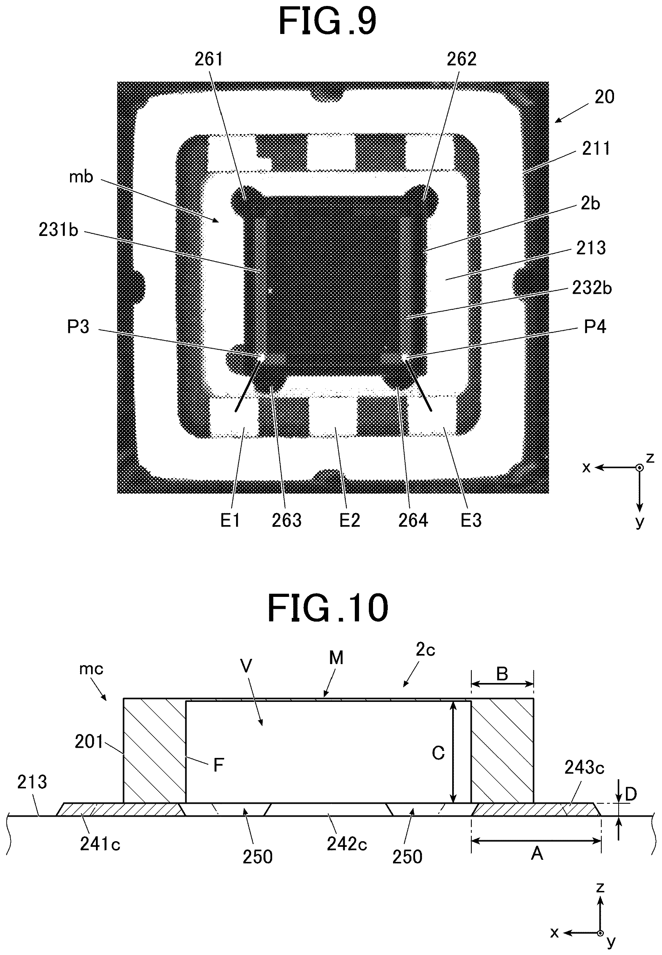

A second modification example of the first embodiment will be described with reference to FIG. 9. FIG. 9 is a diagram illustrating the seal 20 on which a light source 2b in this modification example is mounted.

An optical gas sensor device in this modification example has a configuration in which the light source 2 and the MEMS device m of the optical gas sensor device 100 in the first embodiment are replaced with the light source 2b and a MEMS device mb, respectively. Therefore, the light source 2b will be mainly described, and the description of similar configurations to those in the first embodiment will be omitted.

As illustrated in FIG. 9, the light source 2b has an electrodes 231b and 232b and electrode pads P3 and P4 when viewed from the +z direction side (in the xy plane view). The electrode 231b, 232b is an L-shaped electrode. The electrode pad P3 is electrically connected to the electrode 231b. The electrode pad P4 is electrically connected to the electrode 232b. The light source 2b is arranged on the bottom surface 213 of the seal 20 via adhesive areas 261, 262, 263, and 264. The membrane M of the light source 2b has a circular shape on the xy plane. However, the membrane M of the light source 2b may have a rectangular shape or other shapes on the xy plane.

As illustrated in FIG. 9, the light source 2b is mounted on and wire-bonded to the bottom surface 213 of the seal 20. The electrode pads P3 and P4 is electrically connected to terminals E1 and E3 of the seal 20 via wires, respectively.

The adhesive areas 261 to 264 are located at positions different from the adhesive areas 241 to 244, respectively. However, the adhesive areas 261 to 264 are also intermittently arranged so as to have gaps between a bottom surface 213 and a lower surface of an outer peripheral frame in the bottom surface 213. The adhesive area 263 is arranged in a region surrounding (position corresponding to) the electrode pad P3 in the xy plane of the bottom surface 213. The adhesive 264 is arranged in a region surrounding (position corresponding to) the electrode pad P4 in the xy plane of the bottom surface 213. In addition, in the bottom surface 213, the adhesive areas 261 to 264 are arranged at such positions that the adhesive areas 261 to 264 are adjacent to each other at substantially equal intervals, including the adhesive areas 263 and 264.

In the light source 2b, the membrane M has a round shape (circular shape), and in the intermittent arrangement of the adhesive areas 261 to 264, the ratio of the bonding region is preferably set to 14% to 50%, and the ratio of the bonding region is more preferably set to 20% to 34%.

As described above, according to this modification example, the MEMS device mb including the light source 2b and the optical gas sensor device 100 have the same effects as those in the first embodiment.

### (Second Embodiment)

A second embodiment according to the present disclosure will be described with reference to FIGS. 10 and 11. FIG. 10 is a cross-sectional view of a light source 2c. FIG. 11 is a partially transparent plan view of the light source 2c.

An optical gas sensor device in the present embodiment has a configuration in which the light source 2 of the optical gas sensor device 100 in the first embodiment is replaced with the light source 2c. Therefore, the light source 2c will be mainly described, and the description of similar configurations to those in the first embodiment will be omitted.

As illustrated in FIGS. 10 and 11, in the optical gas sensor device 100, a MEMS device mc includes the light source 2c as a MEMS element, the bottom surface 213 of the seal 20 as a mount, and adhesive areas 241c, 242c, 243c, and 244c. In FIGS. 10 and 11, positions of the adhesive areas 241, 242, 243, and 244 are indicated by alternate long and short dash line for comparison. The light source 2c has a similar configuration to the light source 2 in the first embodiment, and the membrane M has a circular shape on the xy plane. The light source 2c is arranged on the bottom surface 213 of the seal 20 via the adhesive areas 241c, 242c, 243c, and 244c. The adhesive areas 241c to 244c have similar configurations to the adhesive areas 241 to 244, but are arranged at different positions from the adhesive areas 241 to 244, respectively. In the xy plane view, the adhesive area 241c, 243c is offset by an offset amount = (adhesive area diameter A - outer peripheral frame width Bx)/2 or more from a reference position (the midpoint pb1, pb3 of the outer peripheral frame width Bx of the outer peripheral frame F) of the adhesive area 241, 243 toward the outside (radiation direction) of the outer peripheral frame F from a center of the membrane M. In the xy plane view, the adhesive area 242c, 244c is offset by an offset amount = (adhesive area diameter A - outer peripheral frame width B)/2 or more from a reference position (the midpoint pb2, pb4 of the outer peripheral frame width By of the outer peripheral frame F) of the adhesive area 242, 244 toward the outside (radiation direction) of the outer peripheral frame F from a center of the membrane M.

For example, in the xy plane view, a center pc1 of the adhesive area 241c is offset by an offset amount = (A - Bx)/2 from the reference position (the midpoint pb1 of the outer peripheral frame width By) of the adhesive area 241 toward the +x direction side. In the xy plane view, a center pc2 of the adhesive area 242c is offset by an offset amount = (A - By)/2 from the reference position (the midpoint pb2 of the outer peripheral frame width By) of the adhesive area 242 toward the -y direction side. In the xy plane view, a center pc3 of the adhesive area 243c is offset by an offset amount = (A - Bx)/2 from the reference position (the midpoint pb3 of the outer peripheral frame width By) of the adhesive area 243 toward the -x direction side. In the xy plane view, a center pc4 of the adhesive area 244c is offset by an offset amount = (A - By)/2 from the reference position (the midpoint pb4 of the outer peripheral frame width By) of the adhesive area 244 toward the +y direction side. However, in a case of A < Bx, By, the above-described offsets are unnecessary. These offsets align ends of the adhesive areas 241c to 244c with an end of the membrane M.

For example, the light source 2c has dimensions in which a membrane height C is 0.4 mm, an adhesive area diameter A is 0.35 mm, an outer peripheral frame width Bx is 0.2395 mm, and an outer peripheral frame width By is 0.293 mm. In the dimensions, the offset amount in the x-axis direction = (A - Bx)/2 is 55.25 µm, and the offset amount in the y-axis direction = (A - By)/2 is 28.5 µm.

The adhesive areas 241c to 244c are intermittently arranged. The adhesive area 244c is arranged in a region surrounding the electrode pads P1 and P2 in the xy plane. In addition, the adhesive areas 241c to 244c are arranged at positions with equal intervals.

In the conventional configuration, when the bonding material (die attach material) required when the MEMS element is mounted on a module substrate is attached to the membrane, the function is degraded, leading to a reduction in product performance. To overcome that, the application amount of the bonding material is reduced, but it depends on performance (micro application) of an application device. There is known a MEMS element that includes a plurality of side scallops overlapping with each other in a thickness direction of a handle substrate on a wall surface of the handle substrate (support layer) surrounding a back chamber (space) on a lower side of a movable electrode film which is a membrane (see JP 2023-44851A). The MEMS element prevents creeping up of the bonding member covering the wall surface at the time of mounting. Also in a speaker or a microphone that vibrates the membrane of the MEMS element, and a thin film that is movable three-dimensionally when energized, for example, a diaphragm of a MEMS mirror element in addition to the optical gas sensor device, when the bonding material (die attach material) required when the MEMS element is mounted on a module substrate is attached to a movable portion of the thin film, the function is degraded, which significantly adversely affect product performance. However, in order to prevent creeping up of the bonding material onto the thin film such as the membrane of the MEMS element or the diaphragm, a configuration in which a step portion is provided in the MEMS element in JP 2023-44851A or a module substrate which is a mount component and an escape is provided in the bonding material increases component cost due to a complex shape of the structure. In contrast, according to the present embodiment, the MEMS device mc includes the light source 2c as the MEMS element that has a space V surrounded by the outer peripheral frame F of the Si support layer 201 from the four directions and has a thin film covering the space V from an upper surface of the outer peripheral frame F, the ceramic substrate 21 as a mount on which the light source 2c is mounted, and the adhesive areas 241c to 244c having a substantially circular shape. The thin film is the membrane M forming the light source 2c that emits light when energized. The adhesive areas 241c to 244c bond the light source 2c to the ceramic substrate 21, and in the bottom surface 213 as the plane of the ceramic substrate 21, are arranged so that their centers pc1 to pc4 are offset by a predetermined offset amount toward the outside of the outer peripheral frame F from the midpoints pb1 to pb4 of the peripheral frame width B of the light source 2c.

A manufacturing method for the MEMS device mc includes an arrangement process and a mounting process. In the arrangement process, the adhesive areas 241c to 244c having a substantially circular shape are arranged so that their centers pc1 to pc4 are offset by a predetermined offset amount toward the outside of the outer peripheral frame F from the midpoints of the peripheral frame width B of the light source 2c in the bottom surface 213 of the ceramic substrate 21 on which the light source 2c is mounted, the light source 2c having the space V surrounded by the outer peripheral frame F of the Si support layer 201 from the four directions and having the membrane M as a thin film covering the space V from the upper surface of the outer peripheral frame F. In the mounting process, the light source 2c is bonded and mounted on the adhesive areas 241c to 244c.

This reduces the bonding material to the membrane M side, making it possible to prevent creeping up of the bonding material onto the membrane M. At the same time, the device configuration can be simplified compared to a configuration in which a step portion is provided in the mount component and an escape of bonding resin is provided, making it possible to prevent an increase in component cost.

The predetermined amount is (outer peripheral frame width B - bonding area diameter A)/2 or more in the xy plane. This can further prevent creeping up of the bonding material onto the membrane M, as well as simplify the device configuration, making it possible to prevent an increase in component cost.

The optical gas sensor device 100 includes the light source 2c, the AR filter 31 and the λ selection filter 32 as optical filters, the light receiver 4, and the optical cover 1. The light source 2c emits infrared rays to the gas as the detection target. The optical filters transmit the infrared rays emitted from the light source 2c and passing through the gas G as the detection target. The light receiver 4 detects infrared rays incident via the optical filters and generates a detection signal. The optical cover 1 covers the light source 2c, the optical filters, and the light receiver 4, and forms an optical path for infrared rays from the light source 2c to the light receiver 4. The light source 2c and the light receiver 4 are the MEMS elements. Therefore, the optical gas sensor device 100 can prevent creeping up of the bonding material onto the membrane M, as well as simplify the device configuration, making it possible to prevent an increase in component cost.

The mount is the seal 20 that seals the light source 2c. Therefore, the configuration in which the mount is the seal 20 can prevent creeping up of the bonding material onto the membrane M, as well as simplify the device configuration, making it possible to prevent an increase in component cost.

The description in the above-described embodiment is an example of the MEMS device, the optical gas sensor device, the manufacturing method for the MEMS device, and the manufacturing method for the optical gas sensor device according to the present disclosure, and the present disclosure is not limited thereto. For example, at least two among the above-described embodiments and modification examples may be appropriately combined.

In the above-described embodiments, the light source 2 or the light receiver 4 is sealed by the seal 20, 40, but the present disclosure is not limited thereto. It may be configured to surface-mount (chip on board (COB) mount) the light source 2 or the light receiver 4 on the substrate 6 via the plurality of adhesive areas. Also in this configuration, at least one of the light source 2 and the light receiver 4 may be sealed on the substrate 6 by the seal.

Alternatively, it may be configured to surface-mount the light source 2 or the light receiver 4 on a small substrate as a sub-substrate via a plurality of adhesive areas. The small substrate on which the light source 2 or the light receiver 4 is mounted is mounted on the substrate 6 as a main substrate. Also in this configuration, at least one of the light source 2 and the light receiver 4 may be sealed on the small substrate by the seal.

In the above-described embodiments, the MEMS device m, ma, mb, mc has a configuration in which the membrane M forms the light source 2, 2c that emits light when the thin film is energized or the light receiver 4 in the MEMS element having a space surrounded by the outer peripheral frame F from the four directions and having the thin film covering the space from the upper surface of the outer peripheral frame F. However, the present invention is not limited to this configuration. For example, in the MEMS device, the MEMS element may be a speaker or a microphone that vibrates the membrane, or a thin film that is movable three-dimensionally when energized, for example, a diaphragm of a MEMS mirror element.

Other detailed configuration and detailed operation of the optical gas sensor devices 100 in the above-described embodiments and modification examples may also be changed as needed without departing from the gist of the present disclosure.

## Claims

1. A MEMS device, comprising:
a MEMS element (2, 4) that has a space surrounded by an outer peripheral frame from four directions, has a thin film closing the space from an upper surface of the outer peripheral frame, and has an electrode pad (P1 to P4) for wire bonding on the outer peripheral frame;
a mount (213) on which the MEMS element is mounted; and
a plurality of adhesive areas (241 to 244) that bonds the MEMS element to the mount and are arranged on a plane of the mount, wherein
at least one of the plurality of adhesive areas is arranged at a position corresponding to the electrode pad in the plane.

2. The MEMS device according to claim 1, wherein
the plurality of adhesive areas are arranged so that the adhesive areas are adjacent to each other at equal intervals in the plane.

3. The MEMS device according to claim 1 or 2, wherein
the thin film is a membrane forming a light source that emits light when energized or a light receiver.

4. The MEMS device according to any one of claims 1 to 3, wherein
the thin film is a diaphragm that operates three-dimensionally when energized.

5. The MEMS device according to any one of claims 1 to 4, wherein
the plurality of adhesive areas are intermittently arranged so as to have gaps between the mount and a lower surface of the outer peripheral frame in the plane of the mount.

6. The MEMS device according to any one of claims 1 to 5, wherein
the plurality of adhesive areas having a substantially circular shape are arranged so that a center of each of the adhesive areas is offset by a predetermined offset amount toward an outside of the outer peripheral frame of the MEMS element from a midpoint of a width of the outer peripheral frame in the plane of the mount.

7. An optical gas sensor device, comprising:
a light source (2) that emits infrared rays to a gas as a detection target;
an optical filter (32) that transmits infrared rays emitted from the light source and passing through the gas as the detection target;
a light receiver (4) that detects the infrared rays incident via the optical filter and generates a detection signal; and
an optical cover (1) that covers the light source, the optical filter, and the light receiver and forms an optical path for the infrared rays from the light source to the light receiver, wherein
at least one of the light source and the light receiver is the MEMS element of the MEMS device according to any one of claims 1 to 6.

8. The optical gas sensor device according to claim 7, wherein
the mount is a ceramic substrate of a seal that seals the MEMS element.

9. The optical gas sensor device according to claim 7 or 8, wherein
the mount is a substrate on which the light source and the light receiver are mounted.

10. A manufacturing method for a MEMS device, the method comprising:
arranging at least one of a plurality of adhesive areas at a position corresponding to an electrode pad for wire bonding in a plane of a mount on which a MEMS element is mounted which has a space surrounded by an outer peripheral frame from four directions, has a thin film closing the space from an upper surface of the outer peripheral frame, and has the electrode pad on the outer peripheral frame; and
mounting to bond and mount the MEMS element on the plurality of adhesive areas.

11. The manufacturing method according to claim 10, wherein
in the arranging, the plurality of adhesive areas are arranged so that the adhesive areas are adjacent to each other at equal intervals in the plane.

12. The manufacturing method according to claim 10 or 11, wherein
the thin film is a membrane forming a light source that emits light when energized or a light receiver.

13. The manufacturing method according to any one of claims 10 to 12, wherein
in the arranging, the plurality of adhesive areas are intermittently arranged so as to have gaps between the mount and a lower surface of the outer peripheral frame in the plane of the mount.

14. The manufacturing method according to any one of claims 10 to 13, wherein
in the arranging, the plurality of adhesive areas having a substantially circular shape are arranged so that a center of each of the adhesive areas is offset by a predetermined offset amount toward an outside of the outer peripheral frame of the MEMS element from a midpoint of a width of the outer peripheral frame in the plane of the mount.

15. A manufacturing method for an optical gas sensor device that comprises:
a light source that emits infrared rays to a gas as a detection target;
an optical filter that transmits infrared rays emitted from the light source and passing through the gas as the detection target;
a light receiver that detects the infrared rays incident via the optical filter and generates a detection signal; and
an optical cover that covers the light source, the optical filter, and the light receiver and forms an optical path for the infrared rays from the light source to the light receiver, wherein at least one of the light source and the light receiver is the MEMS element, the method comprising:
the arranging and the mounting according to any one of claims 10 to 14.
